Europäisches Patentamt

**European Patent Office**

**Office européen des brevets**

(11) Publication number: **0 154 555**
A2

(12) **EUROPEAN PATENT APPLICATION**

(21) Application number: **85301574.1**

(22) Date of filing: **07.03.85**

(51) Int. Cl.⁴: **H 01 L 31/18**
H 01 L 31/02, H 01 L 31/06
H 01 L 27/14

(30) Priority: **09.03.84 US 588013**

(43) Date of publication of application:
**11.09.85** Bulletin **85/37**

(84) Designated Contracting States:
**BE CH DE FR GB IT LI LU NL SE**

(71) Applicant: **ENERGY CONVERSION DEVICES, INC.**
**1675 West Maple Road**
**Troy Michigan 48084(US)**

(72) Inventor: **Hanak, Joseph J.**
**831 Lawrence Road**
**Lawrenceville New Jersey 08648(US)**

(72) Inventor: **Izu, Masatsugu**
**265 Manor Road**
**Birmingham Michigan 48008(US)**

(72) Inventor: **Nath, Prem.**
**245 Prospect**
**Rochester Michigan 48063(US)**

(72) Inventor: **Young, James**
**2193 Lawndale**
**West Bloomfield Michigan 48044(US)**

(74) Representative: **Jackson, Peter Arthur et al,**
**GILL JENNINGS & EVERY 53-64 Chancery Lane**
**London WC2A 1HN(GB)**

(54) **Electroplated substrate.**

(57) A lightweight, photosensitive structure is formed on a electroplated substrate, characterized by a substantially reduced number of surface defects. The substrate is prepared in an electroforming process by electroplating it on and removing it from the surface of a specifically prepared, substantially defect-free mandrel. The substrate may be provided with a preselected surface finished by either texturing the mandrel or controlling the parameters of the electroplating process to determine the morphology of the deposit. The substrate is especially useful for the fabrication of thin film photoresponsive devices that incorporate specular or diffuse back reflectors, since the substrate surface texture may be controlled to provide for the appropriate type of reflectivity. Large-area, thin film semiconductor devices incorporating the electroplated substrate are readily scribed to form electrically isolated small-area segments for the fabrication of modules, arrays and the like.

FIG 3

ENERGY CONVERSION DEVICES, INC.     Ref: 50/2626/02

<u>ELECTROPLATED SUBSTRATE</u>

Unlike crystalline silicon which is limited to batch processing for the manufacture of solar cells, amorphous silicon alloys can be deposited in multiple layers over large-area substrates to form solar cells in a high volume, continuous processing system. Such continuous processing systems are disclosed in U.S. Patent Nos. 4,400,409 for A Method of Making P-Doped Silicon Films and Devices Made Therefrom; 4,410,588 for Continuous Amorphous Solar Cell Production System; 4,438,723 for Multiple Chamber Deposition and Isolation System and Method; 4,492,181, for Method and Apparatus for Continuously Producing Tandem Amorphous Photovoltaic Cells; and 4,485,125 for Method and Apparatus for Continuously Producing Tandem Amorphous Photovoltaic Cells.  As disclosed in those patents, a substrate may be continuously advanced through a succession of deposition chambers each of which is dedicated to the deposition of a specific semiconductor material.  In making a photovoltaic device of p-i-n type configuration, the first chamber is dedicated for depositing a p-type semiconductor alloy, the second chamber is dedicated for depositing an intrinsic amorphous semiconductor alloy, and the third chamber is dedicated for depositing an n-type semiconductor alloy.

The layers of semiconductor alloy material thus deposited in the vacuum envelope of the deposition apparatus may be utilized to form photoresponsive devices, such as, but not limited to photovoltaic cells that include one or more p-i-n cells or one or more n-i-p cells, Schottky barriers, photodiodes, phototransistors,

- 2 -

or the like. Additionally, by making multiple passes through the succession of deposition chambers, or by providing an additional array of deposition chambers, multiple stacked cells of various configurations may be obtained.

Photoresponsive devices prepared continuously on a moving substrate web are susceptible to various defects that adversely affect performance and that are related to the relatively thin devices. A typical p-type layer may be on the order of 40 nanometers thick, a typical intrinsic layer may be be on the order of 350 nanometers thick, and a typical n-type layer may be on the order of 20 nanometers thick, thereby providing a total thickness of the semiconductor material for a single p-i-n photovoltaic cell of only about 410 nanometers. Therefore, substrate defects, i.e., surface irregularities, however small, may not be readily covered by the thin film of deposited semiconductor material.

Even the highest quality stainless steel used as the substrate or base electrode upon which semiconductor material is deposited has been estimated to contain from 10,000 to 100,000 surface defects per square centimeter. Such irregularities take the form of projections, craters, or other deviations from a smooth finish, and may be less than a micrometer in depth below the surface, height above the surface, or diameter. Depending upon their configuration, size, and the sharpness with which the irregularities deviate from a smooth surface finish, and the manner in which the semiconductor material covers or fails to cover the defects, a low resistance current path through the semiconductor material may be

- 3 -

established. The path is in effect a short circuit between the two electrodes of, for instance, a photovoltaic cell formed from the structure. For instance, a spike projecting from the surface of the substrate electrode may be of too great a height to be covered by the subsequent deposition of semiconductor material, and may therefore, be in direct electrical contact with the second electrode when that second electrode is deposited on the semiconductor material. Likewise, a crater formed in the surface of the substrate electrode may be of too large a diameter or too large a depth to be filled by the subsequent deposition of semiconductor material. The substrate electrode may be sufficiently near the second electrode for electrical current either to bridge the gap that exists between the two electrodes, or through actual use (the photo-induced generation of electrical current) of a photovoltaic device, cause the material of one of the electrodes to migrate toward the other and pass electrical current. Even if the size of a defect is not large, it may include one or more sharp or jagged features, forming nucleation centers that promote non-homogeneous growth of depositing semiconductor material.

In the invention the problem of making high quality, large-area photovoltaic arrays free of active defects and latent defects causing operational failures is solved by depositing amorphous photoresponsive layers on an electroformed metal foil substrate. By preparing the substrate in a continuous electroforming apparatus using a roughened mandrel, a foil free of defects and having a non-specular surface may be formed. A photovoltaic device

- 4 -

or array formed from the deposition of amorphous semiconductor layers on the foil benefits from the diffuse reflecting surface of the foil in addition to providing performance free of current-shunting defects and operational failures. The foil and resulting devices are very lightweight and flexible.

A method of production of a thin electroplated pore-free nickel film is disclosed in U.S. Patent No. 3,767,537 to Selker. The foil is formed by electroplating nickel on a rotating titanium drum and peeling the plated foil from the drum as it rotates. By carefully fabricating the drum with a smooth surface, pore-free foils are prepared. Selker emphasizes the necessity of preparing a specular surface on the rotating drum to avoid the creation of pores in the film, whereas the inventors have determined that a drum with a textured surface produces a foil of great utility in amorphous semiconductor devices. The invention may also employ electroformed films having specular surfaces that function as back reflectors in photovoltaic devices formed by depositing amorphous photoresponsive materials on the foil. Photoresponsive devices may also be formed on foils plated from a bath that forms columnar deposits as a textured surface. Such foils generally have a reflective material plated on them to provide a back reflector in photovoltaic devices.

The invention also provides for manufacturing photovoltaic-ready material by depositing a body of semiconductor material on the deposition surface of a foil substrate, depositing an electrode on the semiconductor body, affixing an insulating support member to the surface of the substrate opposite its deposition surface, dividing the photovoltaic-ready material into large-area photovoltaic cells, dividing the large-area cells into small-area segments, and electrically interconnecting the large-area cells to form a module. The module includes a preselected number of electrically interconnected large-area cells having a preselected arrangement of parallel-series, series and parallel connected small-area segments. In order to effect the various electrical connections, the metallic substrate is scribed with the top electrode or with the semiconductor material (for series connections) or it is left intact (for parallel connections). In a preferred embodiment, the deposition is accomplished on an elongated web of the metallic substrate material, although discrete metallic substrate plates may also be used.

Figure 1 is a fragmentary, cross-sectional view of a tandem photovoltaic device, comprising a plurality of p-i-n type cells.

Figure 2 is a cross-sectional view illustrating deleterious surface defects formed on and in the substrate of a semiconductor device that does not incorporate the substrate of the instant invention.

Figure 3 is a perspective, partially sectioned view illustrating an electroplating bath in which a web of substrate according to the invention, having a substantially defect-free deposition surface, is peeled from a rotating mandrel.

Figure 4 is a perspective view of a second embodiment of the mandrel illustrated in Figure 3, having a textured, substantially defect-free outside surface.

- 6 -

Figure 5A is a cross-sectional view of a photoresponsive device in which the body of semiconductor material and a transparent conductive oxide are deposited on a substrate according to the invention.

Figure 5B is a cross-sectional view of the photoresponsive device of Figure 5A including an insulating support member.

Figure 5C is a cross-sectional view of the photoresponsive device of Figure 5B in which the large-area surface of the transparent conductive oxide and the semiconductor body have been etched to form small-area segments.

Figure 5D is a cross-sectional view of the photoresponsive device of Figure 5C in which the substrate has been etched to mutually electrically isolate the adjacent small-area segments of the device.

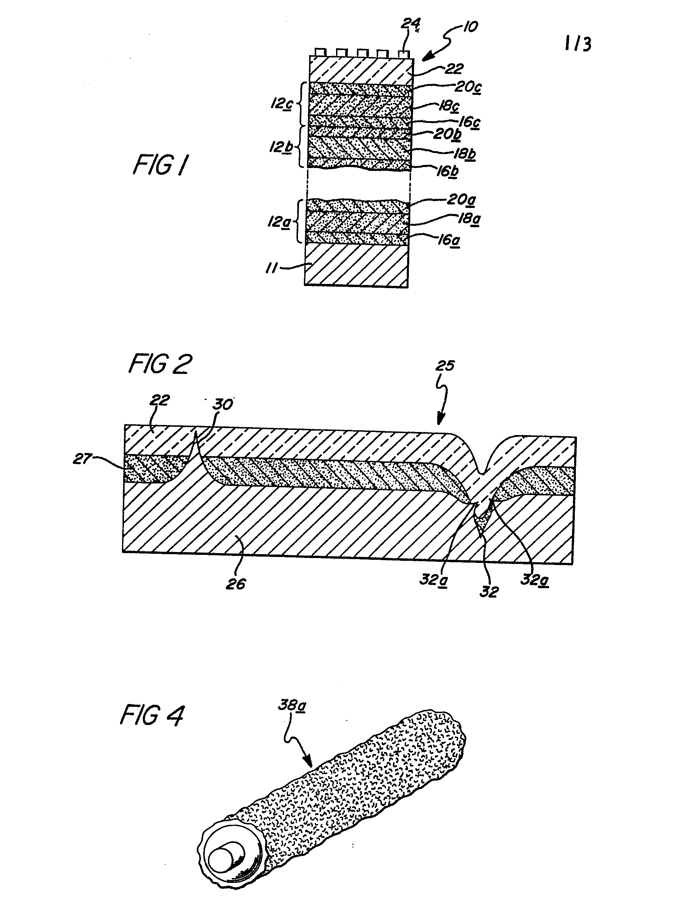

Figure 1 shows a p-i-n type photovoltaic device 10 made up of individual p-i-n type cells 12a, 12b and 12c. Below cell 12a is an electroplated substrate 11 that functions as an electrode. Although certain applications may require a thin oxide layer and/or a series of base contacts and/or a reflecting layer be placed on the substrate prior to the deposition of the photoresponsive material, here the term "substrate" means not only the electroplated material of the invention, but also any elements added to it by preliminary processing.

Each of cells, 12a, 12b and 12c is preferably fabricated from an amorphous semiconductor body containing at least a silicon or germanium alloy. Each of the semiconductor bodies includes an n-type conductivity semiconductor layer 20a, 20b and 20c; intrinsic
semiconductor layer 18a, 18b and 18c; and a p-type conductivity
semiconductor layer 16a, 16b and 16c. As illustrated, cell 12b is an
intermediate cell and, as indicated in Figure 1, additional
intermediate cells may be stacked on the illustrated cells.

Following the deposition of the semiconductor layers, a
further deposition process may be either performed in a separate
environment or as a part of a continuous process. In this step, a
TCO (transparent conductive oxide) layer 22, formed in the preferred
embodiment of indium tin oxide, is deposited on the semiconductor
material as a second electrode. An electrode grid 24 may be applied
to the device where the cell is of a sufficiently large area, or if
the conductivity of the TCO layer 22 is insufficient. Grid 24
shortens the carrier path through the TCO and increases current
collection efficiency.

While the cell illustrated in Figure 1 is a stacked assembly
of p-i-n cells, the instant invention may also be employed with other
cell arrangements such as single p-i-n cells, stacked or single n-i-p
cells, p-n cells, Schottky barrier cells, as well as other thin film
semiconductor devices. Accordingly, in the description and claims
that follow, the layer or layers of semiconductor material disposed
between substrate 11 and electrode 22 will be generally referred to
as the "semiconductor body", or "body of semiconductor material",
meaning combinations of semiconductor layers of various
conductivities and materials that will provide for a flow of
electrical current when appropriately combined with one or more

- 8 -

electrodes and activated by illumination. This flow of electrical current is specifically defined to include the switching of current accomplished by photodiodes and phototransistors, as well as the generation of and collection of current accomplished by photovoltaic — devices such as solar cells.

Figure 2 generally illustrates a photovoltaic device 25 not provided with the defect-free substrate of the invention. Photovoltaic device 25 includes a defect-containing substrate electrode 26, a body of semiconductor material 27 and a electrode 22. A first defect region of substrate electrode 26 is depicted by a raised protuberance or spike 30 extending from the substrate. Protuberance 30 may result from metallurgical irregularities such as impurities, inclusions, growth irregularities, etc. in the material from which the substrate electrode 26 is formed, or from mechanical damage due to nicks, abrasions, etc. occuring during handling of substrate electrode 11, or from particles of dust or other particulate matter contaminating the surface of substrate electrode 26 during handling, processing, etc. Protuberance 30 is of sufficient height so as to be either incompletely or inadequately covered by the deposited layers of semiconductor material 27 or forms a nucleation center that promotes the non-homogeneous deposition of that semiconductor material. In this manner a defect region is formed in the immediate vicinity of protuberance 30.

A second illustrated defect region of substrate electrode 11 is formed in the immediate vicinity of the crater, generally 32. "Crater" means a depression that includes one or more sharp features formed in the deposition surface of substrate electrode 26. If insufficient semiconductor material is deposited in the depressions, electrode 22 and substrate electrode 26 will either electrically approach one another, or come into direct electrical contact with one another. Such craters 32, which may also be referred to as pores, pin holes or pits, may be formed by metallurgical or chemical irregularities in the surface of substrate electrode 26 or mechanical damage due to nicks, abrasions, etc. occurring during handling of substrate electrode 26. Regardless of how crater 32 originates, deposition of the electrode material (in the preferred embodiment, indium tin oxide) on semiconductor material 27 results in the formation of a low resistance current path between electrode material 22 and substrate electrode 26. In this manner, electrical current may be diverted from its normal path of travel through semiconductor material 27. Further, the sharply defined features 32a of crater 32 form nucleating centers about which non-homogeneous semiconductor material may grow.

Operational mode failures are manifested by a sudden catastrophic inability of the photovoltaic device to function under normal operating conditions even though the device has effectively generated current for some period of time. Operational mode failures are caused by a current or voltage driven reaction that intensifies latent defects existing in a photovoltaic device. Extremely high current densities are readily attained across defect sites having low resistivities. For example, a one micrometer square defect having a potential of one volt impressed on it could reach a current density

of 100 Amperes/cm$^2$, a current density that would destroy the device. Further, it is possible that under the influence of the electrical field developed between electrode 22 and substrate electrode 26 when photovoltaic device 25 is operatively employed to produce electrical energy from incident light energy, electrode material may migrate across a defect region such as a crater 32, a protuberance 30, or any sharply defined feature 32a. Since the defect region is incompletely filled in or covered up during the deposition of the semiconductor material, even very slight migration may be sufficient, over a period of time, to establish a low resistance current path effectively short circuiting the device. Once such a low resistance current path is established, even under low intensity illumination, large amounts of current can readily flow through it and damage the overall operation of the photovoltaic device.

The electroplated substrate 11 of the invention prevents the formation of latent or patent defects that can cause low resistance current paths. In particular, substrate 11 drastically reduces the number of operational mode failures while improving the room light yield of large-area photovoltaic cells.

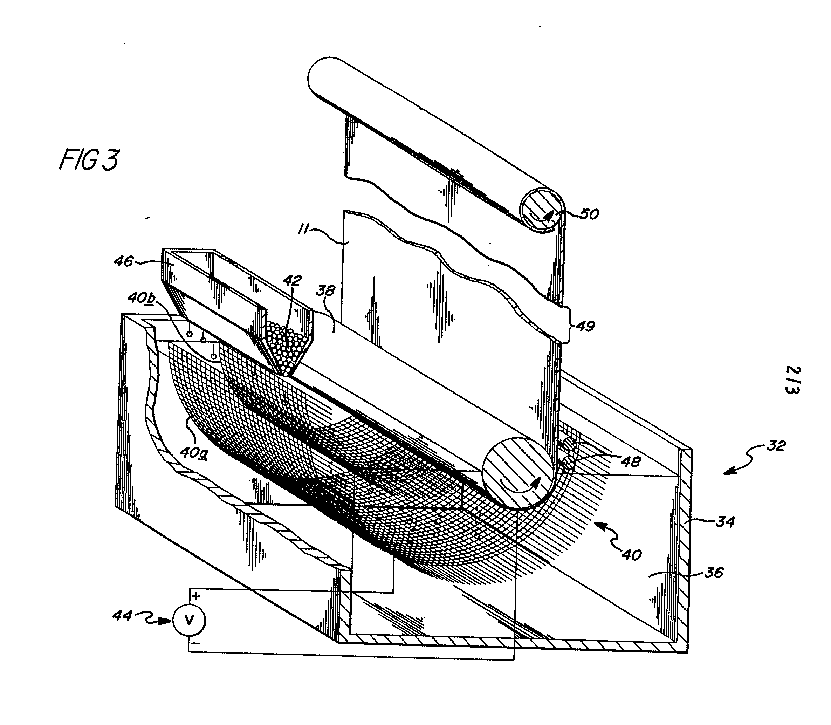

In the invention, the electroforming process, which is well known to those skilled in the plating art, has been adapted for the production of substantially defect-free metallic substrates having a pre-determined surface finish. The substrates are suitable for the fabrication of thin film semiconductor devices, and in particular, for the fabrication of thin film amorphous semiconductor photoresponsive devices. An apparatus 32 for the continuous preparation of a substantially defect free substrate is indicated in Figure 3. Electroforming is basically an electroplating process, and accordingly, apparatus 32 includes a plating tank 34 that contains an electroplating bath or solution 36. Apparatus 32 further includes an elongated, generally cylindrically shaped mandrel 38 upon which the electroplated deposit is formed. Mandrel 38 must have an electrically conductive deposition surface, be resistant to corrosion by plating bath 34, be capable of maintaining a high quality surface finish, be non-reactive with the electroplated material and permit the electroplated deposit to be easily removed from the mandrel.

At least the outer surface of the mandrel 38 is fabricated from titanium, because titanium is an extremely durable metal, may be provided with a high quality surface finish through standard metal finishing techniques, and is readily forms a passivating oxide which protects it from corrosion. Nickel is the preferred material from which to fabricate substrate 11 because nickel does not react with titanium and has a sufficiently different coefficient of thermal expansion to free the electroplated coating from the outside surface of mandrel 38 by the application of heat or cold. While titanium is described herein as the preferred mandrel material, other metals such as stainless steel or aluminum may also be utilized to fabricate mandrels.

Apparatus 32 includes a source of metallic plating material, typically a nickel alloy, depicted in Figure 3 as an anode basket 40 in which a supply of nickel alloy pellets 42 are provided. Anode basket 40 is formed of a conductor, such as titanium, or any other metal which is inert to plating solution 36, maintains nickel pellets 42 in relatively close proximity to, and at a relatively constant distance from, mandrel 38, and provides electrical contact to nickel — pellets 42. Anode basket 40 is generally perforated with mesh-like openings that provide for the free flow of electroplating bath 36, but retain nickel pellets 42 in basket 40.

Anode basket 40 is shown as a curved, dual-walled structure, comprised of two walls 40a and 40b, formed of titanium mesh, with a curvature that is generally concentric with the curvature of mandrel 38. Anode basket 40 is shown as containing only a small number of nickel pellets 42, although in operation the anode basket 40 is generally filled with pellets. The anode basket may be formed as a single walled curved member containing a supply of nickel pellets. Alternatively, a supply of nickel pellets may be introduced into the space between plating tank 34 and a single-walled anode basket, in which case the anode basket and plating tank 34 will cooperate to maintain the nickel pellets in a spaced relationship from the mandrel surface.

A power supply 44 maintains anode basket 40 and nickel pellets 42 at a positive potential and the outside surface of mandrel 38 at a negative potential to promote electroplating of the nickel on the surface of the mandrel that is immersed in plating bath 36. A supply hopper 46 replenishes nickel pellets 42 in anode basket 40 for continuous electroplating. A heater 48 assists in the removal of electroplated deposit 11 from mandrel 38, but cooling apparatus could also be employed instead of the heater.

Although not illustrated, an optional cleaning station may be included for purposes of removing plating process residues from the electroplated substrate. The cleaning station which, for example, may comprise a rinse bath and a dryer, may be positioned in line with apparatus 32 to clean electroplated substrate 11 continuously, as it is produced. Such positioning of the cleaning station is indicated by the break 49 shown in substrate 11 in Figure 3. The apparatus may further include a take-up roller 50 for collecting and storing electroplated substrate 11.

Since electroformed materials are capable of accurately reproducing the surface of the mandrel upon which they are electroplated, it is possible to prepare substantially defect-free substrates by electroforming. The surface of mandrel 38 is treated to provide a substantially defect-free outer surface. It is the object of this treatment process to remove any features that would give rise to the previously described surface defects. The mandrel may be provided with a very smooth, substantially defect-free surface by techniques that may include, by way of illustration, diamond machining, electro-polishing, buffing and the like. For example, a titanium mandrel may be machined to a relatively high quality surface finish, electropolished to remove sharp features and then mechanically polished with progressively finer grits of abrasive culminating with 50 nanometer alumina powder.

In one example of operation, plating tank 34 is filled with a standard nickel sulfamate plating bath to a depth sufficient to cover approximately half of the outside surface of mandrel 38. The plating bath is an aqueous solution comprising of 400 grams per liter of nickel sulfamate, and 30 grams per liter of boric acid, has a pH of 4.5, and is preferably maintained at a temperature of approximately 60°C. Power supply 44 is energized to produce a voltage of approximately 12 volts and a current density of approximately 7500 amperes per square meter at the outside surface of mandrel 38. The mandrel, in the preferred embodiment, is approximately 20 centimeters in diameter and approximately 40 centimeters in length, is rotated at a speed of approximately 2.5 revolutions per minute so as to have a portion of its surface continuously passing through the plating bath. Under these conditions, a coating of nickel, approximately 12.5 micrometers thick, is deposited on a portion of the outside surface of the mandrel. Upon exiting plating bath 36, the outside surface of the mandrel is heated by heating element 48 to assist in separation of electroplated substrate material 11 from the mandrel. Substrate 11, thus produced, is cleaned and wound about take-up reel 50 for storage or downstream processing, such as the deposition of a thin film semiconductor material on it.

The electroplated, substantially defect-free substrate material, thus produced, exhibits a low density of harmful surface defects, making it an ideal candidate for the deposition of thin film semiconductor layers. When the device being fabricated is a photoresponsive device, it is frequently desirable to include a back reflector at the rear surface of the device for redirecting incident light that has not been absorbed, back through the active semiconductor layers a second time. While the surface of the electroplated nickel substrate provided by the electroforming process is highly reflective, it is frequently desirable to include an additional reflective layer to provide for efficient back reflection. Such a reflective layer may be readily applied to the surface of substrate 11 by any process well known in the art. For example, silver or copper may be electroplated on the nickel substrate; and aluminum, or various other alloys may be applied by a vacuum deposition process, such as evaporation or sputtering. Among the preferred materials capable of providing efficient back reflection are silver, aluminum, copper, and their alloys along with other elements such as silicon. It has been found that highly reflective, substantially defect-free surfaces can be formed from the deposition of 20 to 100 nanometers of the aforementioned materials. Frequently, it is desirable to include a thin (2-5 nanometers) layer of a relatively inert, durable metal on the reflective layer to protect the reflective surface from degradation by the ambient atmosphere or subsequent deposition conditions and to promote compatibility and adherance of the reflective layer with the subsequently deposited semiconductor layers. Molybdenum, chromium and titanium are examples of some metals which can be employed in the formation of a protective layer.

Back reflective layers may be deposited on either specular or diffuse substrates. Diffuse back reflectors scatter light in addition to reflecting it. The electroplating process of the instant invention may be used to fabricate a textured, back reflective, substantially defect-free surface, that exhibits diffuse reflectivity, by use of a textured mandrel in electroforming.

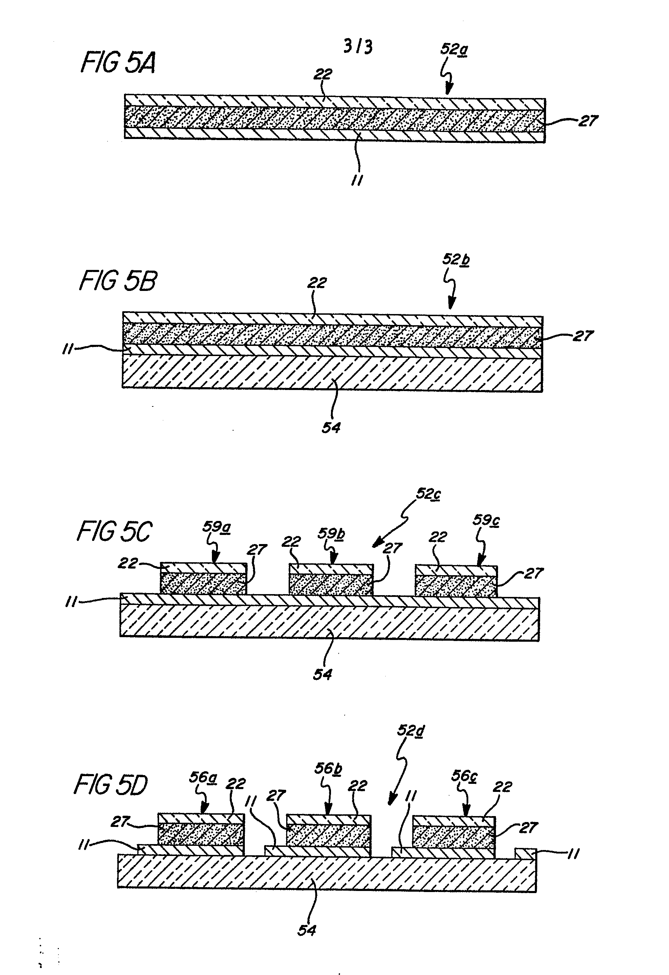

A carefully textured mandrel 38a is depicted in Figure 4. Those defects on a substrate surface that normally shunt current or promote non-homogeneous growth, as discussed with reference to Figure 2, should be distinguished from textured features. The former are generally sharp, irregular departures from a uniform, smooth surface, that cannot be adequately covered by a thin semiconductor layer or that serve to nucleate non-homogeneous growth of that deposited semiconductor material. In contrast, textured features are provided with smoothly varying deviations from the uniform, smooth surface that do not interfere with the uniform, homogeneous deposition of semiconductor layers. The textured features serve to increase the scattering of incident light, increasing light absorption by the active semiconductor layers deposited on the substrate.

The outside surface of mandrel 38a of Figure 4 may be provided with a textured surface by processes such as machining, embossing, engraving, photomasking and etching, and the like. A surface texture may be formed directly upon the outside surface of mandrel 38 or a textured cylinder member may be prepared and affixed to the outside surface of mandrel 38.

Electroforming may also be practiced in a non-continuous mode and may utilize non-cylindrical mandrels. For example, a planar mandrel may be electroplated to produce discrete sheets of planar substrate material or a belt-like mandrel may be employed to produce strips of substrate material.

A textured electroplated substrate may be formed without the use of a textured mandrel surface. As is well known to those skilled in the plating art, the nature of the electroplated deposit will depend upon such parameters as the plating bath composition, plated material composition, current density and temperature. By controlling these parameters, an electroplated deposit exhibiting a preselected morphology upon its growth side may be formed. In apparatus 32 of Figure 3, the growth side of electroplated substrate material 11 is the side of the substrate material that contacts electroplating bath 36, not the side of the substrate material that contacts mandrel 38. In this alternative embodiment, the growth side of electroplated substrate material 11 is optimized for the deposition of the semiconductor layers and mandrel 38 merely serves as a support for the growth of the electroplated deposit. This alternative process offers the advantage that rigorous preparation of the outside mandrel surface is not necessary since the surface morphology will depend upon the plating parameters. A textured surface that is also substantially defect-free may be readily achieved by promoting columnar growth of the nickel deposit. For example, use of the well known "Watts" plating process, in which a plating bath of nickel sulfate, nickel chloride and boric acid is employed, produces a columnar deposit having a matte finish and which may be used as a diffuse back reflector for photoresponsive devices.

The substantially defect-free electroplated substrate may be used to fabricate large-area semiconductor devices, such as photoresponsive devices. The term "large-area device" refers to a semiconductor device of sufficiently large-area that subdivision is necessary to use the device efficiently and practically. For example, large-area photovoltaic cells are subdivided into small-area segments in order to collect photogenerated current more efficiently, to allow for electrical interconnection of the subdivided small-area segments into preselected series and/or parallel connected arrays, or to eliminate problems associated with defective segments. Figure 5A depicts in cross section a large-area photovoltaic cell 52a including an electroplated substantially defect-free substrate layer 11 formed of a nickel alloy in accordance with the principles set forth here. A semiconductor body 27, that may be formed by a plurality of the p-i-n layers as depicted in Figure 1, or any other such photovoltaic body, is deposited on substrate 11. An upper electrode 22 is deposited on and is generally coextensive with semiconductor body 27. Electrode 22 is preferably transparent and formed of a transparent conductive oxide (TCO) material, such as indium tin oxide.

While large-area photovoltaic cell 52 is fully operative and ready for further processing, it is generally desirable to stiffen cell 52 to facilitate handling and increase its durability since the total thickness is only on the order of 50 micrometers. Such thin structures are not sufficiently rigid or dimensionally stable to survive damage caused by sharp bending, wrinkling and abrasion. Accordingly, a dimensionally stable insulating support member 54, depicted in Figure 5B, may be advantageously affixed to the surface of the substrate opposite the surface upon which the semiconductor material has been deposited. Insulating support member 54 may be formed from a wide variety of materials, provided that these materials do not short circuit, react with, or otherwise degrade the semiconductor material that forms photovoltaic cell 52b.

Furthermore, the material from which insulating support layer 54 is formed should have sufficient dielectric strength to resist breakdown when approximately 1000 volts is impressed across its width. Among some of the preferred materials for use in fabricating the insulating support member 54 are: glass, ceramics, synthetic polymers such as ethylene vinyl acetate and polyimides; and composite materials such as fiberglass-epoxy composites. Relatively thick (greater than 200 micrometers) metallic sheets, having an insulating coating formed on at least the substrate contacting surface may also be advantageously employed to form insulating support member 54. Insulating support member 54 may be affixed to the surface of the substrate by conventional techniques well known in the art, such as by lamination, adhesive bonding and the like.

Because of the thinness of electroplated substrate 11, a large-area photoresponsive device, such as large-area photovoltaic cell 52b shown in Figure 5B, may be readily subdivided into a plurality of small-area segments. Such subdivision provides a plurality of discrete small-area segments for special power generating applications, for simply improving the efficiency of current collection, or for providing a preselected array of electrically interconnected small-area segments. More particularly, often it is desirable to form a parallel-connected array of small-area segments, while at other times it is desirable to form a series-connected or mixed series-parallel-connected array.

- 20 -

An insulating-support-backed-large-area cell 52b may be immediately subdivided in a series of processing steps, or it may be stored or shipped for later processing. In this manner, cell 52b provides an inventory of photovoltaic-ready material that may be subsequently prepared according to desired electrical and configurational specifications by relatively simple scribing procedures. Thus, inventory may be kept to a minimum, while customer-specified device configurations may be readily produced.

Referring now to Figure 5C, the large-area photovoltaic cell is divided into a plurality of electrically isolated small-area segments 59a, 59b, 59c. The isolated small-area photovoltaic segments 59a-59c may be formed by any scribing process well known to those skilled in the art, such as chemical etching, laser scribing, water jet scribing, plasma etching and the like. It will be noted that the small-area segments 59a-59c all share a common electrically conductive substrate layer and may therefore be electrically connected into a parallel array by techniques such as those disclosed in U.S. Patent No. 4,419,530.

The portions of the electroplated substrate material between the scribed small-area segments of the semiconductor material may be readily removed by processes such as chemical etching, laser scribing, plasma etching, or water jet scribing to isolate the small-area segments 56a, 56b, 56c electrically as depicted as Figure 5D. The metallic material that forms substrate 11 and semiconductor material 27 have been scribed so as to expose portions of the substrate material between electrically isolated small-area segments

56a-56c. This configuration facilitates electrical interconnection of small-area segments 56a-56c. For example, by interconnecting the bottom metallic substrate layer 11 of a given small-area segment (for example 56c) to electrode 22 of an adjacent small-area segment (for example 56b), a series connection of the two adjacent small-area segments may be established. Likewise, electrical interconnection of substrate electrodes 11 of adjacent small-area segments, and electrical interconnection of electrode 22 of those same small-area segments establishes a parallel electrical interconnection. Obviously, a wide variety of series, parallel, or mixed series-parallel electrical interconnections may be established by utilizing an interconnect structure similar to that depicted in Figure 5D.

While the foregoing description primarily concerns photoresponsive devices, the instant invention may also be readily and advantageously employed in the fabrication of any thin film semiconductor device requiring a substantially defect-free substrate. The instant invention has utility in the fabrication of memory arrays, integrated circuits, photodetectors, as well as any other electronic device formed of thin film layers of semiconductor material, be those layers crystalline, polycrystalline or amorphous.

- 22 -

CLAIMS

1.    A method of fabricating a lightweight photoresponsive structure including a thin, electroformed metallic substrate characterized in:

texturizing the outer surface of a mandrel (38) to produce features diffusely reflecting light;

rotating said mandrel (38) to move its outer surface through an electroplating bath (36);

electroplating a metallic material (11) on said textured outer surface of said mandrel (38) as said mandrel (38) rotates through said bath (36);

peeling said material (11) from said outer surface of said mandrel (38) to replicate said features on at least one side of said material (11); and

depositing a photoresponsive body (27) on said featured side of said material.

2.    A method of fabricating a lightweight photoresponsive structure including a thin, electroformed metallic structure characterized in:

rotating a mandrel (38) to move its outer surface through an electroplating bath (36);

electroplating a metallic material (11) on said outer surface of said mandrel (38) as said mandrel (38) rotates through said bath (36);

- 23 -

growing a columnar deposit of said metallic material on the bath side of said metallic material (11) to establish a featured side;

controlling the morphology of said columnar deposit to produce a diffuse reflecting surface on said featured side of said metallic material (11);

peeling said metallic material (11) from said material (38); and

depositing a photoresponsive body (27) on said featured side of said metallic material (11).

3.    The method of claim 1 or 2 characterized in, before depositing said photoresponsive body (27), depositing a highly reflective coating on said featured side of said metallic material (11).

4.    The method of claim 3 characterized in selecting said reflective coating from the group of elements consisting essentially of silver, aluminum, copper, silicon, and mixtures and alloys thereof.

5.    The method of claim 3 characterized in, before depositing said photoresponsive body, depositing a second layer on said highly reflecting coating to passivate said reflective coating and to improve adherence of said photoresponsive body (27) to said reflective coating.

6.    The method of claim 5 characterized in selecting said second layer from the group of elements consisting essentially of chromium, titanium, molybdenum, and mixtures and alloys thereof.

7.    The method of claims 1 or 2 characterized in depositing an amorphous semiconductor alloy as said photoresponsive body (27).

8. The method of claims 1 or 2 characterized in attaching an electrically insulating support member (54) to said metallic material (11) opposite said photoresponsive body (27).

9. The method of claims 1 or 2 characterized in forming a light transmissive electrode (22) on said photoresponsive body (11).

10. The method of claim 9 characterized in removing portions of said electrode (22) and said photoresponsive body (27) to form a plurality of photoresponsive devices (59a, 59b, 59c ...).

11. The method of claim 10 characterized in removing portions of said metallic material (11) to form a plurality of mutually, electrically isolated photoresponsive devices (56a, 56b, 56c ...).

FIG 1

FIG 2

FIG 4

FIG 3

0154555

3/3

FIG 5A

FIG 5B

FIG 5C

FIG 5D